# EUROPEAN PATENT SPECIFICATION

(11) **EP 1 709 488 B1**
(45) Date of publication and mention of the grant of the patent: **02.11.2011**
(21) Application number: 04814692.2
(22) Date of filing: 20.12.2004
(51) Int. Cl.: G03F 7/095, G03F 7/24, G03F 7/40

(54) **Method of forming photosensitive printing sleeves**
Verfahren zur Herstellung lichtempfindlicher Druckhülsen
Procédé pour la fabrication de manchons d'impression photosensibles

(30) Priority: 30.01.2004 US 768610
(43) Date of publication of application: 11.10.2006
(73) Proprietor: MacDermid Printing Solutions, LLC, Waterbury, Connecticut 06702 (US)
(72) Inventor: KANGA, Rustom, S., Marietta, GA 30008 (US)
(74) Representative: Jenkins, Peter David
(86) International application number: PCT/US2004/042543
(87) International publication number: WO 2005/076082

(56) References cited:
- EP-A- 0 197 601
- EP-A- 0 785 474
- EP-A- 0 940 719
- EP-A- 1 235 102
- WO-A-92/02859
- JP-A- 63 077 050
- US-A- 1 986 052
- US-A- 2 791 504
- US-A- 3 615 450
- US-A- 3 619 601
- US-A- 4 868 090
- US-A- 5 262 275
- US-A- 5 798 019
- US-B1- 6 180 325
- US-B1- 6 413 699
- US-B2- 6 664 999

## Description

### FIELD OF THE INVENTION

The present invention is directed to improved methods of imaging photosensitive printing elements, especially photosensitive printing sleeves. Specifically, the invention relates to methods for improving image fidelity and character geometry of the relief image formed on photoimageable printing sleeves.

### BACKGROUND OF THE INVENTION

Relief image printing elements, including printing plates and cylindrical printing sleeves, are widely used in both flexographic and letterpress processes for printing on a variety of substrates, including paper, corrugated stock, film, foil, and laminates. These relief printing elements typically include a support layer and one or more layers of cured photopolymer deposited on the support layer.

In the conventional process, a printer typically places a masking device, such as a silver halide photographic negative, upon the photopolymer and exposes the negative-bearing element to ultraviolet (UV) light through the negative, thereby causing exposed areas of the element to harden, or cure. After the uncured areas of the element are removed, cured polymer remains as the relief printing surface. Various processes have also been developed to eliminate the use of the negative, offering advantages such as cost efficiency, environmental impact, convenience, and image quality. Many of these processes are referred to as "direct-to-plate" (DTP) processes.

Typically in DTP technology, a computer transfers digital information to a photoablative mask layer via a laser that is in communication with the computer. The laser ablates portions of the photoablative mask layer that have to cure to create an in-situ mask that will ultimately become the relief layer. The printing element is then back-exposed to build the floor and face exposed through the in-situ mask. The area of the mask that was not ablated is removed and the area where the mask was removed is cured and becomes the relief area. The exposed layer is developed by removal of the unexposed, unhardened portions with an air knife, developer solvent, or other means to form the relief image. The printing element can be dried and post-exposed and de-tacked as usual. DTP processes are described for example in U.S. Patent Nos. 5,262,275 and 6,238,837 to Fan and U.S. Patent No. 5,925,500 to Yang et al.

Unlike conventional plate making technology, DTP printing elements typically have the photoablative mask directly on the printing element. Also, in DTP technology, face exposure, i.e., a blanket exposure to actinic radiation of the photopolymerizable layer on the side that does (or, ultimately will) bear the relief, is done in air (in the presence of oxygen), whereas, with conventional plates, exposure is typically done under vacuum.

Due to the presence of oxygen in DTP technology, longer front exposure times are typically required for the transfer of fine detail images_onto_the-photocurable-element. Thus, it is preferable in many applications to include oxygen scavengers in the material of the hotopolymerizable layer to counter the effects of the oxygen, thereby decreasing the exposure time (i.e., increasing the photospeed of the photopolymer). Suitable oxygen scavengers are described for example in U.S. Patent No. 6,413,699 to Kanga.

"Back exposure" refers to a blanket exposure to actinic radiation of the photopolymerizable layer on the side opposite that which does (or, ultimately will) bear the relief. This is typically done through a transparent support layer. Such exposure is used to create a shallow layer of polymerized material, herein referred to as a "floor," on the support side of the photopolymerizable layer. The purpose of the floor is to sensitize the photopolymerizable layer, to establish the depth of the relief and to provide support. It is typically desired to have back exposure times greater than 15-30 seconds. In DTP technology, however, increasing the photo speed often results in a back exposure time of less than 30 seconds. Such short back exposure times are undesirable because variations in the thickness of the floor may be observed. In turn, a non-uniform floor typically contributes to uneven printing due to variation in the relief across the printing element.

Also, since the formation of relief images by photoexposure involves an image having not only length and breadth dimensions, but also a substantial and significant depth dimension, unique demands are placed on the photosensitive system and the photoexposure method which are not encountered in those processes and systems used to form only two dimensional images, such as in conventional photographic or photocopying systems. For many photocurable systems, the operator is forced to make undesired compromises in exposure dose and image quality. There can be a high risk of error in the exposure step, particularly where there is variability in the intensity of the actinic radiation or in the photoresponse of the photocurable material from one lot to another.

Furthermore when a printing sleeve (instead of a printing plate) is exposed to actinic radiation, the source of actinic radiation may, due to the curvature of the surface, hit the photocurable surface at an angle, instead of perpendicular to the photocurable surface, resulting in further loss of image quality. Thus, a need remains in the art to improve the image quality of photosensitive printing elements, especially cylindrical photosensitive printing elements.

The inventors have discovered that the addition of a UV absorbing compound to the cylindrical support layer (or printing sleeve) of the invention, results in an improved floor layer of photopolymerizable material being created in the printing sleeve of the invention. Furthermore, the inventors have discovered that collimating the source(s) of actinic radiation during face exposure of the cylindrical printing element produces a printing sleeve having a higher image quality.

EP-A-0197601 discloses a method of forming a patterned photopolymer coating on a printing roller and also a printing roller with patterned photopolymer coating.

### SUMMARY OF THE INVENTION

The invention is directed to a method of making a cylindrical photosensitive printing element.

The method of making a hollow cylindrical printing sleeve comprising the steps of:
a) providing a photosensitive printing element comprising:
   i) a hollow cylindrical support layer, the hollow cylindrical support layer comprising an actinic radiation absorbing compound uniformly distributed throughout;
   ii) at least one layer of photopolymerizable material deposited on the hollow cylindrical support layer; and
   iii) a masking layer on top of the at least one layer of photopolymerizable material that absorbs radiation at a wavelength used to polymerize the layer of photopolymerizable material;
b) removing portions of the masking layer by exposing the masking layer to laser radiation at a selected wavelength and power;
c) exposing the layer of photopolymerizable material to actinic radiation through the hollow cylindrical support layer to create a floor layer of polymerized material;
d) exposing the surface of the cylindrical sleeve to at least one source of actinic radiation to polymerize the portions of the layer of photopolymerizable material revealed during laser ablation of the masking layer wherein the at least one source of actinic radiation comprises one or more collimated sources of actinic radiation; and
e) developing the photosensitive printing element to remove the masking layer and the unpolymerized portions of the layer of photopolymerizable material to create a relief image on the surface of the photosensitive printing element;
wherein actinic radiation from the at least one source of actinic radiation strikes the photopolymerizable material at an angle that is substantially perpendicular to the surface at the point of impact.

In one embodiment, several sources of actinic radiation are arranged around the surface of the printing sleeve such that the entire surface of the printing sleeve is simultaneously subjected to actinic radiation to polymerize and cure portions of the layer of photopolymerizable material revealed during laser ablation (or removal) of the mask layer.

In another embodiment of the invention, one or more sources of actinic radiation are used to polymerize and cure portions of the photopolymerizable material as the printing element is rotated about its axis to expose the entire surface of the photosensitive element to actinic radiation from the source(s) of actinic radiation.

The one or more sources of actinic radiation, in either of the above described embodiments are collimated so that the actinic radiation strikes the surface of photosensitive printing sleeve at an angle that is substantially perpendicular to the surface of the photosensitive printing element at the point of impact.

### BRIEF DESCRIPTION OF THE FIGURES

The features and advantages of the present invention can be better understood by reference to the accompanying non-scale figures, in which:
Figure 1 is a cross-sectional view of the cylindrical printing sleeve as it is imaged using several sources of actinic radiation.
Figure 2 is a cross-sectional view of the cylindrical printing sleeve of the invention as it is imaged using several sources of actinic radiation that have been collimated.
Figure 3 is a cross-sectional view of the cylindrical printing sleeve of the invention as it is imaged using one source of actinic radiation, wherein the cylindrical printing sleeve is rotated past the one source of actinic radiation.
Figure 4 is a cross-sectional view of the cylindrical printing sleeve of the invention as it is imaged using one source of actinic radiation, wherein the cylindrical printing sleeve is rotated past the one source of actinic radiation, and where the source of actinic radiation is collimated.

Identically labeled elements appearing in different ones of the above-described figures refer to the same elements but may not be referenced in the description for all figures.

### DETAILED DESCRIPTION OF THE INVENTION

The present invention relates generally to improved methods of imaging photosensitive printing elements, in particular, hollow cylindrical printing sleeves with an integral imageable surface thereupon.

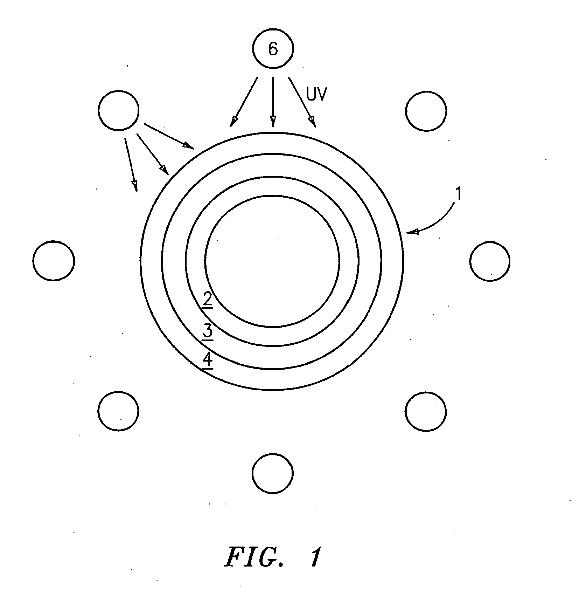

As shown in Figure 1, the photosensitive printing sleeve (1) of the invention generally comprise a hollow cylindrical support layer (2) and at least one layer of photopolymerizable material (3) deposited on the hollow cylindrical support layer (2). In addition, in the case of the DTP photosensitive printing elements of the invention, a masking layer (4) is placed on top of the at least one layer of photopolymerizable material (3) that absorbs radiation at a wavelength used to polymerize the layer of photopolymerizable material and is selectively removable by laser radiation.

A laser is employed to selectively ablate, or remove, the photoablative mask layer such that the areas where the photoablative mask layer was ablated will cure, or harden, upon exposure to the UV light and the areas where the photoablative mask layer was not ablated will remain uncured. In the past, printing sleeves (i.e., the hollow cylindrical support) were nearly opaque to actinic radiation because of their construction, thereby preventing back exposure to create a floor. In accordance with this invention, the inventor proposes use of a uniformly transparent or translucent sleeve thereby allowing back exposure through the sleeve to create a floor. The uncured printing element is then front-exposed to UV light to cure the solid photocurable material in the relief image required.

The hollow cylindrical support layer (2) is preferably formed from a variety of flexible, transparent or translucent materials. Examples of such materials are cellulose films, or plastics such as, for example, PET (polyethylene terephthalate), PEN (polyethylene naphthalate), polyether, polyethylene, polyamide (Kevlar) or nylon. Preferably, the support layer (2) is formed from polyethylene terephthalate (PET).

In a preferred embodiment, the hollow cylindrical support layer (2) is UV-absorbing to counter the increased photo-speed that results from the use of oxygen scavengers or other means (such as increased photoinitiator content or use of highly reactive monomers) used to counter the effects of oxygen inhibition in DTP technology. This can be accomplished either by forming the support layer from a material that is inherently UV-absorbing, i.e., attenuates actinic radiation itself, or by adding a dopant to the material forming the support layer. Preferably, the presence of the UV absorber changes a normally UV transparent or translucent support layer into an attenuation tool that absorbs at least a portion of UV radiation that passes through it. Preferably, the support absorbs between about 80 to about 99%, more preferably between 85 to 95%, and most preferably about 88% of actinic radiation.

In one embodiment, the support layer (2) is formed from a material that is inherently UV-absorbing. Of the above-mentioned materials that are preferably used to form the support layer, only PEN (for example, Kaladex® 1030 and Kaladex® 2000 commercially available from DuPont PET, Hopewell,Va.) is inherently sufficiently UV absorbing. The inventors have found that, when an inherently UV-absorbing support layer is used, the percent of actinic radiation that is absorbed is a function of the thickness of the support layer. The inventor has found that, for example, a PEN support layer having a thickness of about 0.0127cm (5 mils) absorbs about 97 percent of actinic radiation; a PEN support layer having a thickness of about 0.0076cm (3 mils) absorbs about 95 percent of actinic radiation.

In another embodiment of the present invention, a UV-absorbing dopant is added to the material of the cylindrical support layer (2) during manufacture. The spectral range of the flood-exposure lamps used in most applications is about 300-400 nm. Therefore the UV absorbing dopant typically should be active in this range. A uniform distribution of the dopant throughout the support layer is typically achieved during the manufacturing process as the PET, for example, is stretched both in the transverse and machine directions so that the UV absorber is distributed uniformly throughout the PET. Known commercially available UV absorbing PET products include Melinex 943 (DuPont PET, Hopewell, Va.), Skyrol Polyester Type TU84B (SKC LTD, Suwon, S. Korea), Teijin Teonex Type Q51 (Teijin, Japan), and Eastman PET 9921 G0071 (Eastman Chemicals, Kingsport, Tenn.). Further details of the UV-doped support layer are described in U.S. Patent No. 6,413,699 to Kanga.

The term "photocurable material" refers to a solid composition which undergoes polymerization, cross-linking, or any other curing or hardening reaction in response to actinic radiation with the result that the unexposed portions of the material can be selectively separated and removed from the exposed (cured) portions to form a thee dimensional or relief pattern of cured material.

The photocurable layers (3) can include any of the known photopolymers, monomers, initiators, reactive or non-reactive diluents, fillers, and dyes. Preferred photocurable materials include an elastomeric compound, an ethylenically unsaturated compound having at least one terminal ethylene group, and a photoinitiator. Exemplary photocurable materials are disclosed in European Patent Application Nos. 0 456 336 A2 and 0 640 878 A1 to Goss, et al., British Patent No. 1,366,769, U.S. Patent No. 5,223,375 to Berrier, et al., U.S. Patent No. 3,867,153 to MacLahan, U.S. Patent No. 4,264,705 to Allen, U.S. Patent Nos. 4,323,636, 4,323,637, 4,369,246, and 4,423,135 all to Chen, et al., U.S. Patent No. 3,265,765 to Holden, et al., U.S. Patent No. 4,320,188 to Heinz, et al., U.S. Patent No. 4,427,759 to Gruetzrnacher, et al., U.S. Patent No. 4,622,088 to Min, and U.S. Patent No. 5,135,827 to Bohm, et al.

As discussed above, longer front exposure times are typically required for the transfer of fine detail images onto the photocurable element due to the presence of oxygen in DTP technology. Thus, an oxygen scavenger may be included in the photocurable material to counter the effects of the oxygen, thereby decreasing the exposure time (i.e., increasing the photospeed of the photopolymer). Preferably, the oxygen scavenger is a phosphine compound. Triphenylphosphine is particularly preferred.

The masking layer (4) can be any photoablative mask layer known in the art. Examples of such photoablative mask layers are disclosed for example, in U.S. Pat. No. 5,925,500 to Yang, et al., and U.S. Patent Nos. 5,262,275 and 6,238,837 to Fan. In a preferred embodiment, the masking layer (4) comprises a radiation absorbing compound and a binder. The radiation absorbing compound is chosen to be sensitive to the wavelength of the laser and is generally selected from the group consisting of dark inorganic pigments, carbon black, and graphite. Other radiation absorbing compounds would also be known to one skilled in the art. The binder is generally selected from the group consisting of polyamides, and cellulosic binders, such as hydroxypropyl cellulose, although other binders would also be known to one skilled in the art.

A relief image is formed on the surface of the photosensitive printing sleeve (1) in the following manner:
Portions of the masking layer (4) are ablated by exposing the masking layer to laser radiation at a selected wavelength and power of the laser. The power and wavelength of the laser are selected so that the masking layer is ablated without damage to the underlying photopolymerizable layer (3).

The layer of photopolymerizable material (3) is then exposed to actinic radiation through the hollow cylindrical support layer (2) to create a floor layer of polymerized material adjacent to the hollow cylindrical support layer (2). As discussed above, the hollow cylindrical support layer (2) is preferably UV-absorbing to counter the increased photospeed of the printing element in DTP technology.

This is important because forming a uniform floor with a back exposure time of less than about 15 to 20 seconds is often very difficult primarily because the fluorescent lamps that are used typically have a significant variation in intensity across the bank of lights, and often have a significant variation in intensity across any given light in the bank due to variations in the filament. This non-uniformity in the actinic radiation intensity translates directly to nonuniformity of the floor build-up during back exposure. If the back exposure times are too short, this problem is more severe. If the times are longer then the problem is less pronounced. A non-uniform floor build-up results in non-uniform printing because printing presses typically are adjusted for a certain relief. Those areas having shallower relief will print bold. Those having deeper relief may print with poor quality and distortion. As described herein, a modification to the support, or backing, layer, will allow printers to better control floor-formation in DTP technology.

The intensity of flood exposure lamps used in the curing of flexographic printing plates is typically in the range of about 5-25 milliwatts/cm², but intensities can be as high as 50 milliwatts/cm². Therefore, the support layer should be capable of absorbing irradiated light of such intensities from the UV flood lamps.

The surface of the cylindrical sleeve is then subjected to a blanket exposure of actinic radiation to polymerize the portions of the layer of photopolymerizable material revealed during laser ablation of the masking layer. One or more sources of actinic radiation may be used for both the back exposure step and the blanket exposure (or "face exposure") step of the process.

The photocurable materials of the invention should cross-link (cure) and, thereby, harden in at least some actinic wavelength region. As used herein, actinic radiation is radiation capable of effecting a chemical change in an exposed moiety. Actinic radiation includes, for example, amplified (e.g., laser) and non-amplified light, particularly in the UV and infrared wavelength regions. Preferred actinic wavelength regions are from about 250 nm to about 450 nm, more preferably from about 300 nm to about 400 nm, even more preferably from about 320 nm to about 380 nm. One suitable source of actinic radiation is a UV lamps, although other sources would generally be known to one skilled in the art.

Finally, the photosensitive printing element is developed to remove the masking layer and the unpolymerized portions of the layer of photopolymerizable material to create a relief image on the surface of the photosensitive printing element.

In one embodiment of the invention, as shown in Figure 1, several sources of actinic radiation (6), i.e., UV lamps are arranged around the surface of the photosensitive printing sleeve such that the entire surface of the printing sleeve is simultaneously subjected to actinic radiation to cure the relief image. The UV-lamps (6) are generally selected so that the length of the lamps is approximately the length of the cylindrical printing sleeve to provide adequate exposure of the entire surface of the printing sleeve.

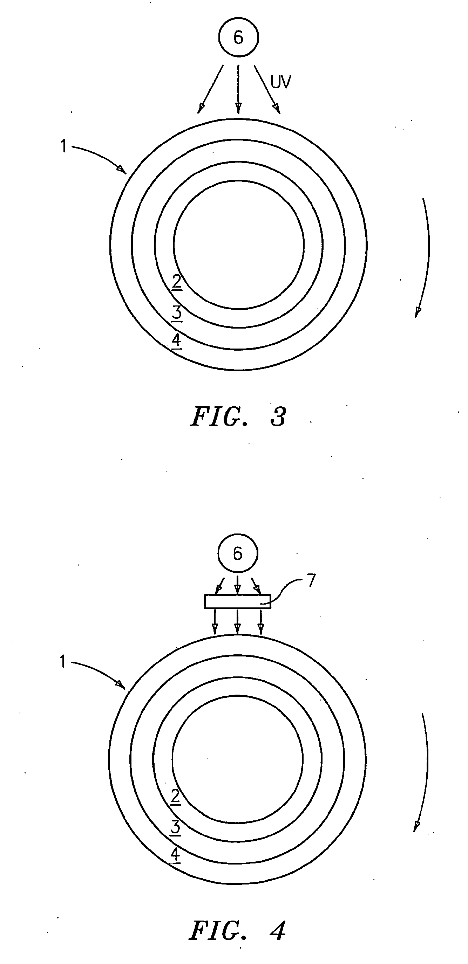

In an alternate embodiment of the invention, as shown in Figure 3, one or more sources of actinic radiation (6) are used and the photosensitive printing element (1) is rotated about its axis to expose the entire surface of the photosensitive element to actinic radiation from the source(s) of actinic radiation (6). The UV-lamp is generally selected so that the length of the lamp is approximately the length of the cylindrical printing sleeve to provide adequate exposure of the entire surface of the printing sleeve.

The quality of the relief image is improved by collimating the one or more sources of actinic radiation. Collimation is a term used to describe the quality of a light source. To "collimate" means to make straight. In terms of the instant application, the term refers to the light rays striking the photosensitive printing sleeve at an angle that is substantially perpendicular to the surface of the photosensitive printing element at the point of impact. One suitable collimator is described in U.S. Patent No. 6,245,487 to Randall. Other suitable collimators would also be known to those skilled in the art.

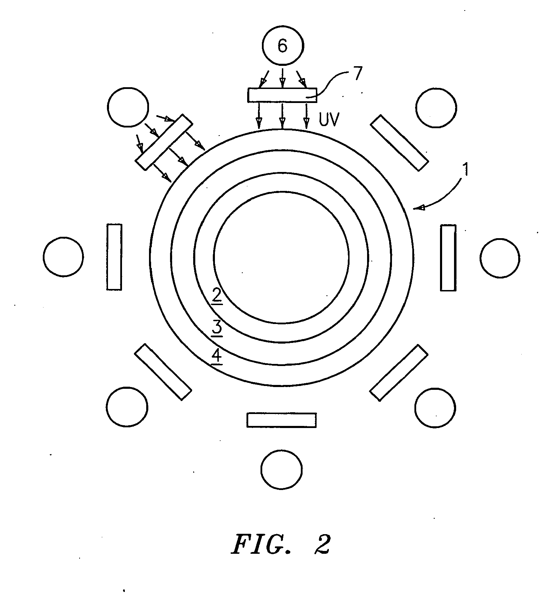

As shown in Figures 2 and 4, the UV lamps (or other actinic radiation source(s)) may be collimated by positioning at least one collimator (7) between each of the UV-lamps (6) and the photopolymerizable printing sleeve (1). The collimator (7) generally has first and second opposing major faces and comprises at least one cell that extends from the first major face to the second major face. The collimator (7) is defined by at least one surface that substantially absorbs actinic radiation incident upon the surface. During operation, actinic radiation passes first through the collimator (7) before reaching the photopolymerizable printing sleeve (1).

The collimators of the present invention contain at least one cell and, preferably, a plurality of cells. These cells are defined by walls that absorb radiation emitted from an actinic radiation source at severely oblique angles to the plane of the negative. The cell walls preferably absorb this radiation such that the remaining rays pass through the cells of the collimator in a direction substantially parallel to the negative plane. Radiation that is emitted by the source at more moderate oblique angles, i.e., radiation that does not contact the cell walls, is unaltered by passage through the collimator.

The surfaces of the cell walls are substantially non-reflective. Non-reflective characteristics can be imparted to the cell walls in a number of ways. The cell walls can be (or coated to be) a color that is radiation absorbing, i.e., black. Alternatively, the cell walls can be textured, or both coated and textured with a material that inherently absorbs radiation. These and other features of the collimator of the invention are described more fully in U.S. Patent No. 6,245,487 to Randall.

## Claims

1. A method of making a hollow cylindrical printing sleeve, the method comprising:
a) providing a photosensitive printing element comprising:
i) a hollow cylindrical support layer, the hollow cylindrical support layer comprising an actinic radiation absorbing compound uniformly distributed throughout;
ii) at least one layer of photopolymerizable material deposited on the hollow cylindrical support layer; and
iii) a masking layer on top of the at least one layer of photopolymerizable material that absorbs radiation at a wavelength used to polymerize the layer of photopolymerizable material;
b) removing portions of the masking layer by exposing the masking layer to laser radiation at a selected wavelength and power;
c) exposing the layer of photopolymerizable material to actinic radiation through the hollow cylindrical support layer to create a floor layer of polymerized material;
d) exposing the surface of the cylindrical sleeve to at least one source of actinic radiation to polymerize the portions of the layer of photopolymerizable material revealed during laser ablation of the masking layer wherein the at least one source of actinic radiation comprises one or more collimated sources of actinic radiation; and
e) developing the photosensitive printing element to remove the masking layer and the unpolymerized portions of the layer of photopolymerizable material to create a relief image on the surface of the photosensitive printing element;
wherein actinic radiation from the at least one source of actinic radiation strikes the photopolymerizable material at an angle that is substantially perpendicular to the surface at the point of impact.

2. The method of claim 1 wherein the hollow cylindrical base layer having an actinic radiation absorbing material uniformly distributed throughout absorbs between 85 and 95 percent actinic radiation.

3. The method of claim 1 wherein the hollow cylindrical support layer is polyethylene terephthalate.

4. The method of claim 1 wherein the masking layer comprises a radiation absorbing compound and a binder.

5. The method of claim 4 wherein the radiation absorbing compound is selected from the group consisting of dark inorganic pigments, carbon black, and graphite.

6. The method of claim 1 wherein the at least one source of actinic radiation is collimated.

7. The method of claim 1 wherein the at least one source of actinic radiation comprises ultraviolet lamps arranged around the photosensitive printing element; said ultraviolet lamps simultaneously exposing the entire surface of the photosensitive printing element to actinic radiation.

8. The method of claim 7 wherein the ultraviolet lamps are collimated by positioning at least one collimator between the ultraviolet lamps and the photopolymerizable printing element, said at least one collimator having first and second opposing major faces and comprising at least one cell that extends from the first major face to the second major face, wherein the at least one collimator is defined by at least one surface that substantially absorbs actinic radiation incident upon the surface and actinic radiation passes through the collimator before reaching the photopolymerizable printing sleeve.

9. The method of claim 1 wherein the photosensitive printing element is positioned adjacent to the at least one source of actinic radiation and said photosensitive printing element is rotated about its axis to expose the entire surface of the photosensitive element to actinic radiation from the at least one source of actinic radiation.

10. The method of claim 9 wherein the at least one source of actinic radiation is an ultraviolet lamp and said ultraviolet lamp is collimated by positioning a collimator between the ultraviolet lamp and the photopolymerizable printing sleeve, said collimator having first and second opposing major faces and comprising at least one cell that extends from the first major face to the second major face, wherein the collimator is defined by at least one surface that substantially absorbs actinic radiation incident upon the surface and actinic radiation passes from the ultraviolet lamp through the collimator before reaching the photopolymerizable printing sleeve.

## Patentansprüche

1. Verfahren zur Herstellung einer hohlen zylindrischen Druckhülse, wobei das Verfahren aufweist :
a) Bereitstellen eines photoempfindlichen Druckelements, aufweisend:
i) eine hohle zylindrische Stützschicht, wobei die hohle zylindrische Stützschicht eine aktinische Strahlung absorbierende Zusammensetzung aufweist, welche gleichmäßig durchwegs verteilt ist;
ii) mindestens eine Schicht von photopolymerisierbarem Material, welche an der hohlen zylindrischen Stützschicht angelagert ist; und
iii) eine Abdeckschicht auf der mindestens einen Schicht von photopolymerisierbarem Material, welche Strahlung bei einer Wellenlänge absorbiert, welche verwendet wird, um die Schicht von photopolymerisierbarem Material zu polymerisieren;
b) Entfernen von Teilen der Abdeckschicht, indem die Abdeckschicht Laserstrahlung bei einer ausgewählten Wellenlänge und Stärke ausgesetzt wird;
c) Aussetzen der Schicht von photopolymerisierbarem Material aktinischer Strahlung durch die hohle zylindrische Stützschicht, um eine Bodenschicht von polymerisiertem Material zu erzeugen;
d) Aussetzen der Oberfläche der zylindrischen Hülse mindestens einer Quelle von aktinischer Strahlung, um die Teile der Schicht von photopolymerisierbarem Material zu polymerisieren, welche während Laserablation der Abdeckschicht offengelegt wurden, wobei die mindestens eine Quelle von aktinischer Strahlung eine oder mehrere kollimierte Quellen aktinischer Strahlung aufweist; und
e) Entwickeln des photoempfindlichen Druckelements, um die Abdeckschicht zu entfernen und die nichtpolymerisierten Teile der Schicht von photopolymerisierbarem Material, um ein Reliefbild an der Oberfläche des photoempfindlichen Druckelements zu erzeugen;
wobei aktinische Strahlung von der mindestens einen Quelle von aktinischer Strahlung auf das photopolymerisierbare Material in einem Winkel auftrifft, welcher im Wesentlichen senkrecht zu der Oberfläche am Auftreffpunkt ist.

2. Verfahren nach Anspruch 1, wobei die hohle zylindrische Basisschicht, welche ein aktinische Strahlung absorbierendes Material aufweist, welches gleichmäßig durchwegs verteilt ist, zwischen 85 und 95 Prozent aktinischer Strahlung absorbiert.

3. Verfahren nach Anspruch 1, wobei die hohle zylindrische Stützschicht Polyethylen-Terephthalat ist.

4. Verfahren nach Anspruch 1, wobei die Abdeckschicht eine Strahlung absorbierende Zusammensetzung und einen Binder aufweist.

5. Verfahren nach Anspruch 4, wobei die Strahlung absorbierende Zusammensetzung ausgewählt ist aus der Gruppe bestehend aus dunklen anorganischen Pigmenten, Ruß und Graphit.

6. Verfahren nach Anspruch 1, wobei die mindestens eine Quelle von aktinischer Strahlung kollimiert ist.

7. Verfahren nach Anspruch 1, wobei die mindestens eine Quelle von aktinischer Strahlung Ultraviolettlampen aufweist, welche um das photoempfindliche Druckelement herum angeordnet sind, wobei die Ultraviolettlampen die gesamte Oberfläche des photoempfindlichen Druckelements gleichzeitig aktinischer Strahlung aussetzen.

8. Verfahren nach Anspruch 7, wobei die Ultraviolettlampen kollimiert sind durch Positionieren mindestens eines Kollimators zwischen den Ultraviolettlampen und dem photopolymerisierbaren Druckelement, wobei der mindestens eine Kollimator erste und zweite gegenüberliegende Hauptflächen aufweist und mindestens eine Zelle aufweist, welche sich von der ersten Hauptfläche zu der zweiten Hauptfläche erstreckt, wobei der mindestens eine Kollimator definiert ist durch mindestens eine Oberfläche, welche im Wesentlichen aktinische Strahlung, welche auf die Oberfläche auftrifft, absorbiert und wobei aktinische Strahlung durch den Kollimator vor dem Erreichen der photopolymerisierbaren Druckhülse hindurch gelangt.

9. Verfahren nach Anspruch 1, wobei das photoempfindliche Druckelement benachbart zu der mindestens einen Quelle von aktinischer Strahlung positioniert ist und wobei das photoempfindliche Druckelement um seine Achse rotiert wird, um die gesamte Oberfläche des photoempfindlichen Druckelements aktinischer Strahlung von der mindestens einen Quelle von aktinischer Strahlung auszusetzen.

10. Verfahren nach Anspruch 9, wobei die mindestens eine Quelle von aktinischer Strahlung eine Ultraviolettlampe ist und die Ultraviolettlampe kollimiert ist durch Positionierung eines Kollimators zwischen der Ultraviolettlampe und der photopolymerisierbaren Druckhülse, wobei der Kollimator erste und zweite gegenüberliegende Hauptflächen aufweist und mindestens eine Zelle umfasst, welche sich von der ersten Hauptfläche zu der zweiten Hauptfläche erstreckt, wobei der Kollimator definiert ist durch mindestens eine Oberfläche, welche im Wesentlichen aktinische Strahlung absorbiert, welche auf die Oberfläche auftrifft und wobei aktinische Strahlung von der Ultraviolettlampe durch den Kollimator vor Erreichen der photopolymerisierbaren Druckhülse hindurch gelangt.

## Revendications

1. Procédé de fabrication d'un manchon d'impression cylindrique creux, le procédé comprenant les étapes consistant à :
a) fournir un élément d'impression photosensible qui comprend:
i) une couche de support cylindrique creuse, la couche de support cylindrique creuse comprenant un composé qui absorbe un rayonnement actinique réparti partout de manière uniforme;
ii) au moins une couche de matériau pouvant être photopolymérisé déposée sur la couche de support cylindrique creuse; et
iii) une couche de masquage située sur la ou les couches de matériau pouvant être photopolymérisé qui absorbe un rayonnement à une longueur d'onde utilisée de façon à polymériser la couche de matériau pouvant être photopolymérisé;
b) retirer des parties de la couche de masquage en exposant la couche de masquage à un rayonnement laser à une longueur d'onde et à une puissance sélectionnées ;
c) exposer la couche de matériau pouvant être photopolymérisé à un rayonnement actinique à travers la couche de support cylindrique creuse de façon à créer une couche de base de matériau polymérisé;
d) exposer la surface du manchon cylindrique au moins à une source de rayonnement actinique de façon à polymériser les parties de la couche de matériau pouvant être photopolymérisé révélées au cours d'une ablation par laser de la couche de masquage, dans lequel la ou les sources de rayonnement actinique comprennent une ou plusieurs sources collimatées de rayonnement actinique ; et
e) développer l'élément d'impression photosensible de façon à retirer la couche de masquage et les parties non polymérisées de la couche de matériau pouvant être photopolymérisé de façon à créer une image en relief sur la surface de l'élément d'impression photosensible;
dans lequel le rayonnement actinique en provenance de la ou des sources de rayonnement actinique frappe le matériau pouvant être photopolymérisé sous un angle qui est sensiblement perpendiculaire à la surface au niveau du point d'impact.

2. Procédé selon la revendication 1, dans lequel la couche de base cylindrique creuse qui présente un matériau qui absorbe un rayonnement actinique réparti partout de manière uniforme, absorbe entre 85 et 95 pour cent de rayonnement actinique.

3. Procédé selon la revendication 1, dans lequel la couche de support cylindrique creuse est en polyéthylène téréphtalate.

4. Procédé selon la revendication 1, dans lequel la couche de masquage comprend un composé qui absorbe un rayonnement et un liant.

5. Procédé selon la revendication 4, dans lequel le composé qui absorbe un rayonnement est sélectionné dans le groupe constitué par des pigments inorganiques foncés, du noir de carbone, et du graphite.

6. Procédé selon la revendication 1, dans lequel la ou les sources de rayonnement actinique son collimatées.

7. Procédé selon la revendication 1, dans lequel la ou les sources de rayonnement actinique comprennent des lampes à ultraviolets disposées autour de l'élément d'impression photosensible, lesdites lampes à ultraviolets exposant de manière simultanée toute la surface de l'élément d'impression photosensible au rayonnement actinique.

8. Procédé selon la revendication 7, dans lequel les lampes à ultraviolets sont collimatées en plaçant au moins un collimateur entre les lampes à ultraviolets et l'élément d'impression pouvant être photopolymérisé, ledit ou lesdits collimateurs présentant des première et seconde faces principales opposées et comprenant au moins une cellule qui s'étend à partir de la première face principale vers la seconde face principale, dans lequel le ou les collimateurs sont définis par au moins une surface qui absorbe sensiblement un rayonnement actinique incident sur la surface et le rayonnement actinique passe à travers le collimateur avant d'atteindre le manchon d'impression pouvant être photopolymérisé.

9. Procédé selon la revendication 1, dans lequel l'élément d'impression photosensible est placé à côté de la ou des sources de rayonnement actinique et ledit élément d'impression photosensible est mis en rotation autour de son axe de façon à exposer toute la surface de l'élément photosensible au rayonnement actinique de la ou des sources de rayonnement actinique.

10. Procédé selon la revendication 9, dans lequel la ou les sources de rayonnement actinique sont constituées par une lampe à ultraviolets et ladite lampe à ultraviolets est collimatée en plaçant un collimateur entre la lampe à ultraviolets et le manchon d'impression pouvant être photopolymérisé, ledit collimateur présentant des première et seconde faces principales opposées et comprenant au moins une cellule qui s'étend à partir de la première face principale vers la seconde face principale, dans lequel ledit collimateur est défini par au moins une surface qui absorbe sensiblement un rayonnement actinique incident sur la surface et le rayonnement actinique provient de la lampe à ultraviolets et passe à travers le collimateur avant d'atteindre le manchon d'impression pouvant être photopolymérisé.
